# EUROPEAN PATENT APPLICATION

(11) **EP 4 485 706 A1**
(43) Date of publication of application: **01.01.2025**
(21) Application number: 22932375.3
(22) Date of filing: 08.04.2022
(51) Int. Cl.: H01R 13/52, H01B 7/04

(54) **FLEXIBLE CABLE, AND ELECTRONIC DEVICE HAVING SAME**

(30) Priority: 15.03.2022 KR 20220031807
(71) Applicant: LG Electronics Inc., Yeongdeungpo-gu Seoul 07336 (KR)
(72) Inventor: CHOI, Wonkyong, Seoul 06772 (KR); PARK, Sangho, Seoul 06772 (KR)
(74) Representative: Schornack, Oliver
(86) International application number: PCT/KR2022/005082
(87) International publication number: WO 2023/177008

(57) **Abstract**

An electronic device comprises: a case made of a metal material; a circuit board positioned on the surface of the case; a condensation sensor that comprises a pair of sensor electrodes formed with a predetermined gap on the circuit board and detects the formation of condensation when a current flows between the sensor electrodes; and a control unit that locks an operation when the condensation sensor detects condensation. The electronic device can detect condensation at an early stage, thus preventing malfunction or damage to components.

## Description

### TECHNICAL FIELD

The present disclosure relates to a flexible cable capable of preventing condensation from being introduced into a cable connector and an electronic device having the same.

### BACKGROUND ART

With growth of information society, demand for various display devices has increased. In order to satisfy such demand, in recent years, a liquid crystal display (LCD), a field emission display (FED), a plasma display panel (PDP), and an electroluminescent device have been developed as display devices.

A liquid crystal panel of the liquid crystal display includes a liquid crystal layer and a TFT substrate and a color filter substrate opposite each other in the state in which the liquid crystal layer is interposed therebetween, wherein a picture is displayed using light provided from a backlight unit.

An active matrix type organic light-emitting display has come onto the market as an example of the electroluminescent device. Since the organic light-emitting display is self-emissive, the organic light-emitting display has no backlight, compared to the liquid crystal display, and has merits in terms of response time and viewing angle, and therefore the organic light-emitting display has attracted attention as a next-generation display.

When the organic light-emitting display is used as a display panel, the organic light-emitting display itself is made of a flexible material, the rigidity of a module cover supporting the organic light-emitting display is important.

The display device may be mounted indoors or outdoors, and may be used in an area in which a daily temperature range is large or an annual temperature range depending on a region.

In particular, when the display device is used in a high-temperature and high-humidity region, condensation may occur, and when a dew drop penetrates a component, defects and malfunction may occur.

### DISCLOSURE

### TECHNICAL TASKS

An object of the present disclosure is to provide a flexible cable capable of preventing condensation from being introduced into a cable connector to minimize malfunction and defects caused by condensation and an electronic device having the same.

### TECHNICAL SOLUTIONS

In one technical aspect of the present disclosure, provided is an electronic device, including a case of a metal material, a circuit board located on a surface of the case, a cable connector located on the circuit board, and a flexible cable having an end portion inserted into the cable connector to be connected to another component, the flexible cable including a connection part having a signal line located therein, a terminal part having an electrode located at each of both end portions of the connection part to be connected to the signal line, and a drip tray located on one surface of the connection part.

The trip tray may include an adhesive part located at one end to be attached to the flexible cable and a gutter extending from the adhesive part to be concavely bent.

The gutter may include a first folding part bent in a direction spaced apart from the adhesive part and a second folding part bent at the first folding part to form a V-shaped gutter with the first folding part.

An angle between the first folding part and the second folding part may be twice greater than that formed between the first folding part and the flexible cable.

The terminal part may include a first terminal part located at a lower end portion of the flexible cable and a second terminal part located at an upper end portion of the flexible cable, and the gutter may have a shape protruding toward the first terminal part.

The drip tray may be located adjacent to the first terminal part.

One surface of the connection part may face the case.

The other end of the drip tray may be in contact with the case.

The drip tray may include a waterproof and rigid material.

The electronic device may further include a drip cover attached adjacent to the terminal part of the other surface of the flexible cable to cover the terminal part so as to cover the cable connector based on coupling the flexible cable to the cable connector.

In another technical aspect of the present disclosure, provided is a flexible cable, including a connection part having a signal line located therein, a terminal part located at each of both end portions of the connection part and having an electrode connected to the signal line, and a drip tray located on one surface of the connection part.

The trip tray may include an adhesive part located at one end to be attached to the flexible cable and a gutter extending from the adhesive part to be concavely bent.

The gutter may include a first folding part bent in a direction spaced apart from the adhesive part and a second folding part bent at the first folding part to form a V-shaped gutter with the first folding part.

An angle between the first folding part and the second folding part may be twice greater than that formed between the first folding part and the flexible cable.

The terminal part may include a first terminal part located at a lower end portion of the flexible cable and a second terminal part located at an upper end portion of the flexible cable, and the gutter may have a shape protruding toward the first terminal part.

### ADVANTAGEOUS EFFECTS

The electronic device of the present disclosure may prevent condensation from being introduced into the cable connector by blocking or bypassing a flow path through which the condensation flows.

Since the damage caused by the inflow of moisture is prevented, the lifespan of a product may be increased.

Further, the present disclosure may be implemented by attaching only a simple structure to an existing flexible cable so as to be easily applicable, and may performed in the same manner as the existing installation method when a flexible cable is installed.

Effects obtainable from the present disclosure may be non-limited by the above-mentioned effects. And, other unmentioned effects can be clearly understood from the following description by those having ordinary skill in the technical field to which the present disclosure pertains.

### DESCRIPTION OF DRAWINGS

FIG. 1 is a block diagram illustrating components of a display device according to the present disclosure.
FIG. 2 is a perspective view showing an example of the display device according to the present disclosure.
FIG. 3 is an exploded perspective view showing the example of the display device according to the present disclosure.
FIG. 4 is a rear perspective view showing the example of the display device according to the present disclosure.
FIG. 5 is a diagram for explaining a condensation phenomenon.
FIG. 6 is a diagram illustrating an example of an electronic component disposed on a rear surface of a cover bottom of a display device, according to the present disclosure.
FIG. 7 is a diagram illustrating a side view for explaining a dew condensation phenomenon through a flexible cable.
FIG. 8 is a diagram illustrating a flexible cable of the present disclosure.
FIG. 9 is a diagram illustrating a side view of a flexible cable according to an embodiment of the present disclosure.

### BEST MODE

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Meanwhile, an image display device 100 described in this specification is, for example, an intelligent image display device 100 having a computer supporting function in addition to a broadcast reception function, wherein an Internet function may be added while the broadcast reception function is devotedly performed, whereby an interface that is more conveniently used, such as a handwriting type input device, a touchscreen, or a space remote control, may be provided. In addition, the image display device may be connected to the Internet or a computer through support of a wired or wireless Internet function, whereby various functions, such as e-mail, web browsing, banking, or gaming, may be executed. For such various functions, a standardized general-purpose OS may be used.

In the image display device described in the present disclosure, therefore, various applications may be freely added or deleted, for example, on a general-purpose OS kernel, whereby various user friendly functions may be executed. More specifically, the image display device may be a network TV, an Hbb TV, or a smart TV, and is applicable to a smartphone depending on circumstances.

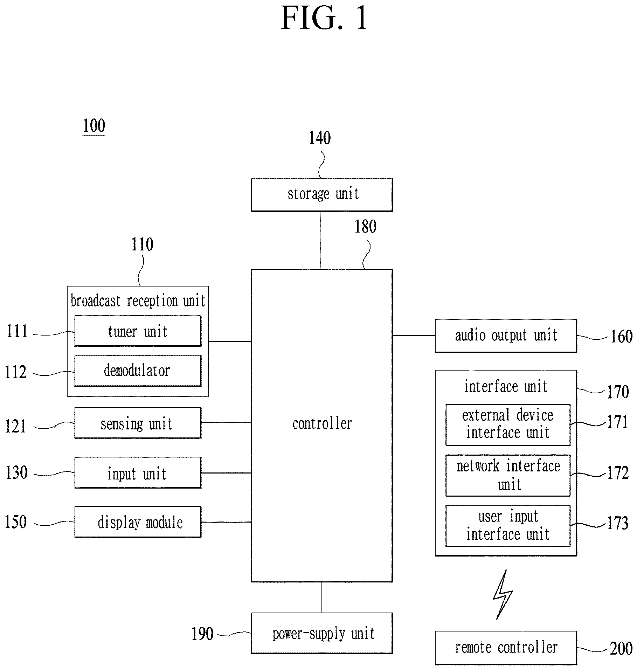

FIG. 1 is a block diagram illustrating components of a display device 100. The display device 100 may include a broadcast reception unit 110, an external device interface unit 171, a network interface unit 172, a storage unit 140, a user input interface unit 173, an input unit 130, a controller 180, a display module 150, an audio output unit 160, and/or a power supply unit 190.

The broadcast reception unit 110 may include a tuner unit 111 and a demodulation unit 112.

Unlike the figure, on the other hand, the display device 100 may include only the external device interface unit 171 and the network interface unit 172, among the broadcast reception unit 110, the external device interface unit 171, and the network interface unit 172. That is, the display device 100 may not include the broadcast reception unit 110.

The tuner unit 111 may select a broadcast signal corresponding to a channel selected by a user or any one of all pre-stored channels, among broadcast signals received through an antenna (not shown) or a cable (not shown). The tuner unit 111 may convert the selected broadcast signal into an intermediate frequency signal or a baseband video or audio signal.

For example, when the selected broadcast signal is a digital broadcast signal, the tuner unit 111 may convert the broadcast signal into a digital IF (DIF) signal, and when the selected broadcast signal is an analog broadcast signal, the tuner unit 111 may convert the broadcast signal into an analog baseband video or audio (CVBS/SIF) signal. That is, the tuner unit 111 may process the digital broadcast signal or the analog broadcast signal. The analog baseband video or audio (CVBS/SIF) signal output from the tuner unit 111 may be directly input to the controller 180.

Meanwhile, the tuner unit 111 may sequentially select broadcast signals of all broadcast channels stored through a channel memory function, among received broadcast signals, and may convert each of the selected broadcast signals into an intermediate frequency signal or a baseband video or audio signal.

Meanwhile, the tuner unit 111 may include a plurality of tuners in order to receive broadcast signals of a plurality of channels. Alternatively, a single tuner may simultaneously receive broadcast signals of a plurality of channels.

The demodulation unit 112 may receive the digital IF (DIF) signal converted by the tuner unit 111, and may perform demodulation. After performing demodulation and channel decryption, the demodulation unit 112 may output a stream signal (TS). At this time, the stream signal may be a multiplexed image, audio, or data signal.

The stream signal output from the demodulation unit 112 may be input to the controller 180. After performing demultiplexing and image/audio signal processing, the controller 180 may output an image through the display module 150, and may output audio through the audio output unit 160.

The sensing unit 120 is a device configured to sense change inside or outside the display device 100. For example, the sensing unit 120 may include at least one of a proximity sensor, an illumination sensor, a touch sensor, an infrared (IR) sensor, an ultrasonic sensor, an optical sensor (e.g. a camera), an audio sensor (e.g. a microphone), a battery gauge, and an environmental sensor (e.g. a hygrometer or a thermometer).

The controller 180 may check the state of the display device 100 based on information collected by the sensing unit, and when a problem occurs, may inform a user of the same or may solve the problem, whereby the controller may perform control such that the display device is maintained in the best state.

In addition, the controller may differently control the content, quality, and size of an image provided to the display module 150 based on a viewer or ambient light sensed by the sensing unit in order to provide the optimum viewing environment. With progress of a smart TV, a large number of functions have been loaded in the display device, and the sensing unit 20 has also been increased in number.

The input unit 130 may be provided at one side of a main body of the display device 100. For example, the input unit 130 may include a touchpad or a physical button. The input unit 130 may receive various user commands related to the operation of the display device 100, and may transmit control signals corresponding to the received commands to the controller 180.

With a decrease in size of a bezel of the display device 100, many display devices 100 have been configured such that the number of physical button type input units 130 exposed to the outside is minimized in recent years. Instead, a minimum number of physical buttons is located at the rear surface or the side surface of the display device, and the display device may receive user input through the touchpad or the user input interface unit 173, a description of which will follow, using a remote controller 200.

The storage unit 140 may store programs for signal processing and control in the controller 180, and may store a processed image, audio, or data signal. For example, the storage unit 140 may store application programs designed to execute various tasks that can be processed by the controller 180, and may selectively provide some of the stored application programs in response to request of the controller 180.

Programs stored in the storage unit 140 are not particularly restricted as long as the programs can be executed by the controller 180. The storage unit 140 may temporarily store an image, audio, or data signal received from an external device through the external device interface unit 171. The storage unit 140 may store information about a predetermined broadcast channel through a channel memory function, such as a channel map.

FIG. 1 shows an embodiment in which the storage unit 140 and the controller 180 are separately provided; however, the present disclosure is not limited thereto. The storage unit 140 may be included in the controller 180.

The storage unit 140 may include at least one of a volatile memory (e.g. DRAM, SRAM, or SDRAM), a nonvolatile memory (e.g. flash memory), a hard disk drive (HDD), and a solid-state drive (SSD). The display module 150 may convert an image signal, a data signal, an OSD signal, and a control signal processed by the controller 180 or an image signal, a data signal, and a control signal received from the interface unit 171 to generate a driving signal. The display module 150 may include a display panel 181 having a plurality of pixels.

Each of the plurality of pixels in the display panel may include RGB subpixels. Alternatively, each of the plurality of pixels in the display panel may include RGBW subpixels. The display module 150 may convert an image signal, a data signal, an OSD signal, and a control signal processed by the controller 180 to generate a driving signal for the plurality of pixels.

A plasma display panel (PDP), a liquid crystal display (LCD), an organic light-emitting diode (OLED), or a flexible display may be used as the display module 150, and a 3D display may also be used. The 3D display 130 may be classified as a non-glasses type display or a glasses type display.

Meanwhile, the display module 150 may be constituted by a touchscreen, whereby an input device may also be used in addition to an output device.

The audio output unit 160 receives an audio signal processed by the controller 180 and outputs the same as audio.

The interface unit 170 serves as a path to various kinds of external devices connected to the display device 100. The interface unit may include a wireless system using an antenna as well as a wired system configured to transmit and receive data through a cable.

The interface unit 170 may include at least one of a wired/wireless headset port, an external charger port, a wired/wireless data port, a memory card port, a port for connection with a device having an identification module, an audio input/output (I/O) port, a video input/output (I/O) port, and an earphone port.

The broadcast reception unit 110 may be included as an example of the wireless system, and a mobile communication signal, a short-range communication signal, and a wireless Internet signal as well as a broadcast signal may be included.

The external device interface unit 171 may transmit or receive data to or from a connected external device. To this end, the external device interface unit 171 may include an A/V input and output unit (not shown).

The external device interface unit 171 may be connected to an external device, such as a digital versatile disc (DVD) player, a Blu-ray player, a game console, a camera, a camcorder, a computer (laptop computer), or a set-top box, in wired/wireless manner, and may perform input/output operation for the external device.

In addition, the external device interface unit 171 may establish a communication network with various remote controllers 200 in order to receive a control signal related to the operation of the display device 100 from each remote controller 200 or to transmit data related to the operation of the display device 100 to each remote controller 200.

The external device interface unit 171 may include a wireless communication unit (not shown) for short-range wireless communication with another electronic device. The external device interface unit 171 may exchange data with a mobile terminal adjacent thereto through the wireless communication unit (not shown). Particularly, in a mirroring mode, the external device interface unit 171 may receive device information, information of an application that is executed, and an image of the application from the mobile terminal.

The network interface unit 172 may provide an interface for connection of the display device 100 with a wired/wireless network including the Internet. For example, the network interface unit 172 may receive content or data provided by an Internet or content provider or a network operator through the network. Meanwhile, the network interface unit 172 may include a communication module (not shown) for connection with the wired/wireless network.

The external device interface unit 171 and/or the network interface unit 172 may include a communication module for short-range communication, such as Wi-Fi, Bluetooth, Bluetooth Low Energy (BLE), ZigBee, or Near Field Communication (NFC), or a communication module for cellular communication, such as Long-Term Evolution (LTE), LTE Advance (LTE-A), Code Division Multiple Access (CDMA), Wideband CDMA (WCDMA), Universal Mobile Telecommunications System (UMTS), or Wireless Broadband (WiBro).

The user input interface unit 173 may transmit a user input signal to the controller 180, or may transmit a signal from the controller 180 to a user. For example, the user input interface unit may transmit/receive a user input signal, such as power on/off, channel selection, or screen setting, to/from the remote controller 200, may transmit a user input signal, such as a power key, a channel key, a volume key, or a setting value, input from a local key (not shown) to the controller 180, may transmit a user input signal input from a sensor unit (not shown) configured to sense user gesture to the controller 180, or may transmit a signal from the controller 180 to the sensor unit.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

The controller 180 may demultiplex a stream input through the tuner unit 111, the demodulation unit 112, the external device interface unit 171, or the network interface unit 172, or may process demultiplexed signals to generate and output a signal for image or audio output.

An image signal processed by the controller 180 may be input to the display module 150, which may display an image corresponding to the image signal. In addition, the image signal processed by the controller 180 may be input to an external output device through the external device interface unit 171.

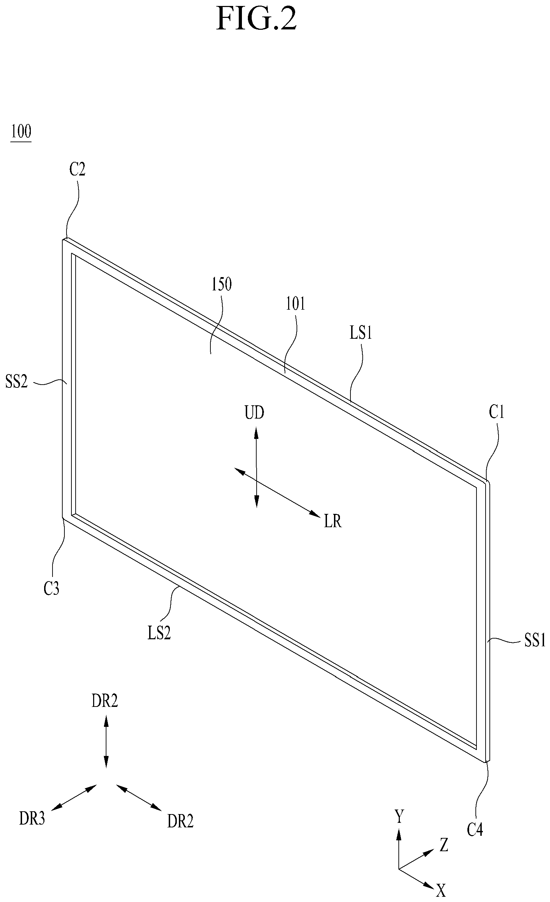

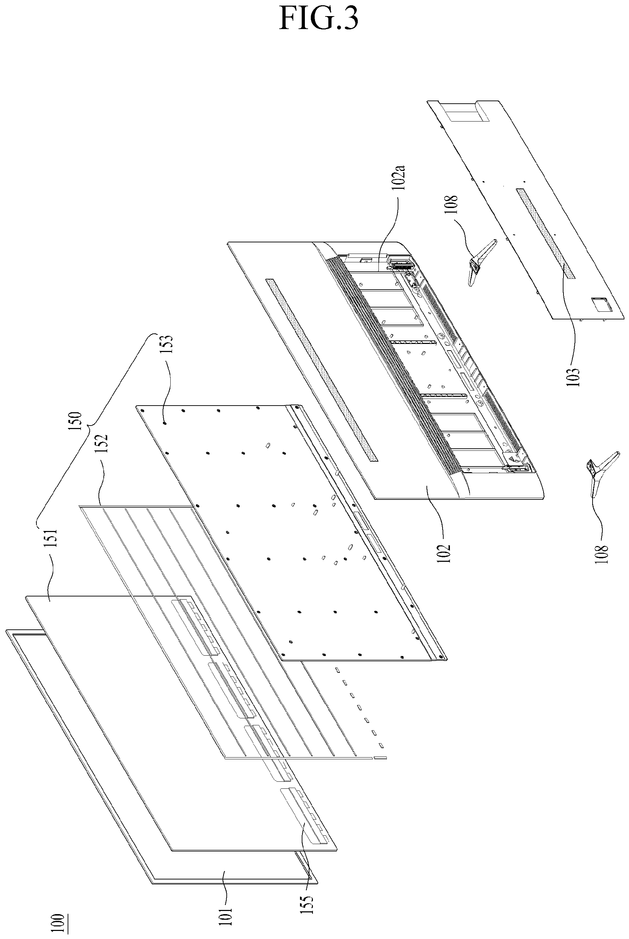

An audio signal processed by the controller 180 may be output through the audio output unit 160. In addition, the audio signal processed by the controller 180 may be input to an external output device through the external device interface unit 171. Although not shown in FIG. 2, the controller 180 may include a demultiplexing unit and an image processing unit, which will be described below with reference to FIG. 3.

Further, the controller 180 may control the overall operation of the display device 100. For example, the controller 180 may control the tuner unit 111 such that a broadcast corresponding to a channel selected by a user or a pre-stored channel is tuned.

In addition, the controller 180 may control the display device 100 according to a user command input through the user input interface unit 173 or an internal program. Meanwhile, the controller 180 may control the display module 150 to display an image. At this time, the image displayed on the display module 150 may be a still image or video, or may be a 2D image or a 3D image.

Meanwhile, the controller 180 may perform control such that a predetermined 2D object is displayed in an image displayed on the display module 150. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

Meanwhile, the display device 100 may further include a photographing unit (not shown). The photographing unit may photograph a user. The photographing unit may be implemented by one camera; however, the present disclosure is not limited thereto. The photographing unit may be implemented by a plurality of cameras. Meanwhile, the photographing unit may be embedded in the display device 100 above the display module 150, or may be separately disposed. Image information photographed by the photographing unit may be input to the controller 180.

The controller 180 may recognize the location of a user based on an image captured by the photographing unit. For example, the controller 180 may recognize the distance between the user and the display device 100 (z-axis coordinate). Further, the controller 180 may recognize an x-axis coordinate and a y-axis coordinate in the display module 150 corresponding to the location of the user.

The controller 180 may sense user gesture based on the image captured by the photographing unit, a signal sensed by the sensor unit, or a combination thereof.

The power supply unit 190 may supply power to the components of the display device 100. In particular, the power supply unit may supply power to the controller 180, which may be implemented in the form of a system on chip (SOC), the display module 150 for image display, and the audio output unit 160 for audio output.

Specifically, the power supply unit 190 may include an AC/DC converter (not shown) configured to convert AC power into DC power and a DC/DC converter (not shown) configured to convert the level of the DC power.

Meanwhile, the power supply unit 190 serves to distribute power supplied from the outside to the respective components of the display device. The power supply unit 190 may be directly connected to an external power supply in order to supply AC power, or may include a battery so as to be used by charging.

In the former case, a cable is used, and the power supply unit is difficult to move or the movement range of the power supply unit is limited. In the latter case, the power supply unit is free to move, but the weight of the power supply unit is increased in proportion to the weight of the battery, the volume of the power supply unit is increased, and, for charging, the power supply unit must be directly connected to a power cable or must be coupled to a charging holder (not shown) that supplies power for a predetermined time.

The charging holder may be connected to the display device through a terminal exposed to the outside, or the battery mounted in the power supply unit may be charged in a wireless manner when the power supply unit approaches the charging holder.

The remote controller 200 may transmit user input to the user input interface unit 173. To this end, the remote controller 200 may use Bluetooth communication, radio frequency (RF) communication, infrared radiation communication, ultra-wideband (UWB) communication, or ZigBee communication. In addition, the remote controller 200 may receive an image, audio, or data signal output from the user input interface unit 173 so as to be displayed thereon or audibly output therefrom.

Meanwhile, the display device 100 may be a stationary or movable digital broadcast receiver capable of receiving a digital broadcast.

Meanwhile, the block diagram of the display device 100 shown in FIG. 1 is for an embodiment of the present disclosure, and elements of the block diagram may be integrated, added, or omitted depending on specifications of an actually implemented display device 100.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

FIG. 2 is a front perspective view showing an example of the display device.

Referring to FIG. 2, the display device 100 may have a rectangular shape including a first long side LS1, a second long side LS2 opposite the first long side LS1, a first short side SS1 adjacent to the first long side LS1 and the second long side LS2, and a second short side SS2 opposite the first short side SS1.

Here, the area of the first short side SS1 may be referred to as a first side area, the area of the second short side SS2 may be referred to as a second side area opposite the first side area, the area of the first long side LS1 may be referred to as a third side area adjacent to the first side area and the second side area and located between the first side area and the second side area, and the area of the second long side LS2 may be referred to as a fourth side area adjacent to the first side area and the second side area, located between the first side area and the second side area, and opposite the third side area.

In addition, the lengths of the first and second long sides LS1 and LS2 are shown and described as being greater than the lengths of the first and second short sides SS1 and SS2, for convenience of description; however, the lengths of the first and second long sides LS1 and LS2 may be approximately equal to the lengths of the first and second short sides SS1 and SS2.

Also, in the following description, a first direction DR1 may be a direction parallel to the long sides LS1 and LS2 of the display device 100, and a second direction DR2 may be a direction parallel to the short sides SS1 and SS2 of the display device 100. A third direction DR3 may be a direction perpendicular to the first direction DR1 and/or the second direction DR2.

From a different point of view, the side of the display device 100 on which a picture is displayed may be referred to as a front side or a front surface. When the display device 100 displays the picture, the side of the display device 100 from which the picture cannot be viewed may be referred to as a rear side or a rear surface. When viewing the display device 100 from the front side or the front surface, the side of the first long side LS1 may be referred to as an upper side or an upper surface. In the same manner, the side of the second long side LS2 may be referred to as a lower side or a lower surface. In the same manner, the side of the first short side SS1 may be referred to as a right side or a right surface, and the side of the second short side SS2 may be referred to as a left side or a left surface.

In addition, the first long side LS1, the second long side LS2, the first short side SS1, and the second short side SS2 may be referred to edges 351 of the display device 100. In addition, points at which the first long side LS1, the second long side LS2, the first short side SS1, and the second short side SS2 are joined to each other may be referred to as corners. For example, a point at which the first long side LS1 and the first short side SS1 are joined to each other may be a first corner C1, a point at which the first long side LS1 and the second short side SS2 are joined to each other may be a second corner C2, a point at which the second short side SS2 and the second long side LS2 are joined to each other may be a third corner C3, and a point at which the second long side LS2 and the first short side SS1 are joined to each other may be a fourth corner C4.

Here, a direction from the first short side SS1 to the second short side SS2 or a direction from the second short side SS2 to the first short side SS1 may be referred to as a leftward-rightward direction LR. A direction from the first long side LS1 to the second long side LS2 or a direction from the second long side LS2 to the first long side LS1 may be referred to as a vertical direction UD.

The display device includes a display module, which occupies a major portion of the front surface thereof, and a case configured to cover the rear surface and the side surface of the display module, the case being configured to package the display module.

In recent years, the display device 100 has used a flexible display module 150, such as light-emitting diodes (LED) or organic light-emitting diodes (OLED), in order to implement a curved screen.

Light is supplied to an LCD, which was mainly used conventionally, through a backlight unit, since the LCD is not self-emissive. The backlight unit is a device that supplies light emitted from a light source to a liquid crystal uniformly located in front thereof. As the backlight unit has been gradually thinned, a thin LCD has been implemented. However, it is difficult to implement the backlight unit using a flexible material. If the backlight unit is curved, it is difficult to supply uniform light to the liquid crystal, whereby the brightness of a screen is changed.

In contrast, the LED or the OLED may be implemented so as to be curved, since an element constituting each pixel is self-emissive, and therefore no backlight unit is used. In addition, since each element is self-emissive, the brightness of the element is not affected even though the positional relationship between adjacent elements is changed, and therefore it is possible to implement a curved display module 150 using the LED or the OLED.

An organic light-emitting diode (OLED) panel appeared in earnest in mid 2010 and has rapidly replaced the LCD in the small- or medium-sized display market. The OLED is a display manufactured using a self-emissive phenomenon of an organic compound in which the organic compound emits light when current flows in the organic compound. The response time of the OLED is shorter than the response time of the LCD, and therefore afterimages hardly appear when video is implemented.

The OLED is an emissive display product that uses three fluorescent organic compounds having a self-emissive function, such as red, green, and blue fluorescent organic compounds and that uses a phenomenon in which electrons injected at a negative electrode and a positive electrode and particles having positive charges are combined in the organic compounds to emit light, and therefore a backlight unit, which deteriorates color, is not needed.

A light-emitting diode (LED) panel is based on technology of using one LED element as one pixel. Since it is possible to reduce the size of the LED element, compared to a conventional device, it is possible to implement a curved display module 150. The conventional device, which is called an LED TV, uses the LED as a light source of a backlight unit that supplies light to the LCD, and therefore the LED does not constitute a screen.

The display module includes a display panel and a coupling magnet, a first power supply unit, and a first signal module located at a rear surface of the display panel. The display panel may include a plurality of pixels R, G, and B. The plurality of pixels R, G, and B may be formed at intersections between a plurality of data lines and a plurality of gate lines. The plurality of pixels R, G, and B may be disposed or arranged in a matrix form.

For example, the plurality of pixels R, G, and B may include a red subpixel 'R', a green subpixel 'G', and a blue subpixel 'B'. The plurality of pixels R, G, and B may include a white subpixel 'W'.

The side of the display module 150 on which a picture is displayed may be referred to as a front side or a front surface. When the display module 150 displays the picture, the side of the display module 150 from which the picture cannot be viewed may be referred to as a rear side or a rear surface.

FIG. 3 is an exploded diagram illustrating a display device 100 utilizing an OLED panel as a display module. Since an OLED device is self-luminous, it is possible to implement a thin display module 150 without a backlight unit.

The display device may include a display module 150, a case top 101 covering a circumference of a front surface of the display module 150 and surrounding a circumference of a side surface, a cover bottom 102 covering a rear surface of the display module 150, and a back cover 103 covering at least a portion of a rear surface of the cover bottom 102.

The case stop 101, the cover bottom 102, and the back cover 103 for protecting the display module 150 may be collectively referred to as a case.

As the display module 150 is thinned, the case may be thinned and the thickness of the case top 101 constituting a bezel located around the front surface of the display panel may also be reduced or omitted.

Unlike a liquid crystal panel, in the case of an OLED display panel, the case top 101 may be omitted because the backlight unit is omitted and a laterally exposed layered structure is simpler than the liquid crystal display panel.

The display module includes a display panel 151 outputting an image and a support panel 153 supporting a rear surface of the display panel 151, and the two members may be coupled to each other using an adhesive member 152 such as OCA.

A flexible substrate extending from an end of the display panel 151 may be bent in a rear direction to be connected to a control board mounted on the cover bottom 102. When a liquid crystal panel is used, the display panel 151 may be formed by mounting a light source substrate, an optical sheet, and a liquid crystal panel in the stated order by using a panel guide.

A display device mounted on a wall includes a structure (not shown) fastened to the wall on the rear surface of the display device 100, and a display device that stands on the floor may include a stand 108 extending below the display module 150 of the display device 100.

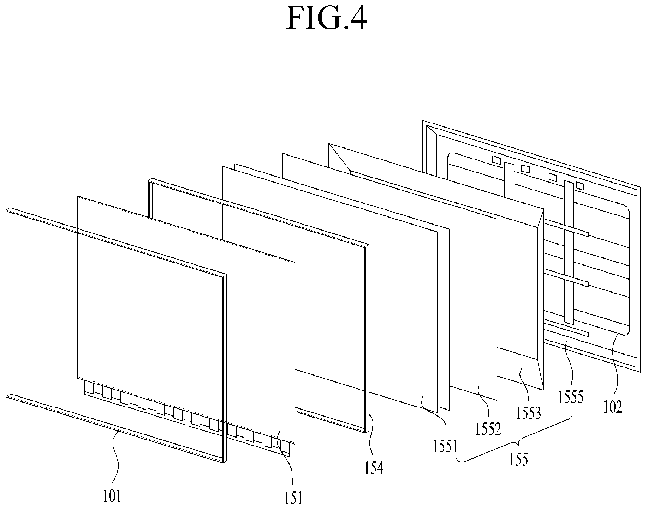

FIG. 4 is an exploded perspective view of a liquid crystal display device 100. Referring to FIG. 4, a liquid crystal display is shown. In the case of a liquid crystal display, a liquid crystal panel 151 outputting an image and a light source supplying light from a rear surface of the liquid crystal panel 151 may be needed to include a backlight unit 155.

An LED is arranged as a light source 1555 emitting light, and a reflective sheet 1553, a light guide plate 1552, an optical sheet 1551, and the like may be disposed on a front surface of the backlight unit 155. The backlight unit 155 may further include a frame-shaped guide panel 154 disposed between the liquid crystal panel and the backlight unit 155 to align a position of each layer of the backlight unit 155 composed of several films and to align the position of each layer of the backlight unit 155 with the liquid crystal panel.

The display module 150 may be positioned between the case top 101 located on the front surface and the cover bottom 102 located on the rear surface. As the size of the display device is reduced, a space between the case top and the cover bottom 102 is narrowed, and thus the display device is vulnerable to heat dissipation.

To dissipate heat generated by the display module 150, the cover bottom 102 may use a material having a high thermal conductivity. For example, the cover bottom 102 may include a metal material and have a high thermal conductivity, and thus a temperature thereof may be lower than the surrounding temperature. In particular, if the temperature rises in the early morning while the temperature of the cover bottom 102 is low due to the temperature dropping overnight, condensation may occur because the temperature of the cover bottom 102 is lower than the surrounding temperature.

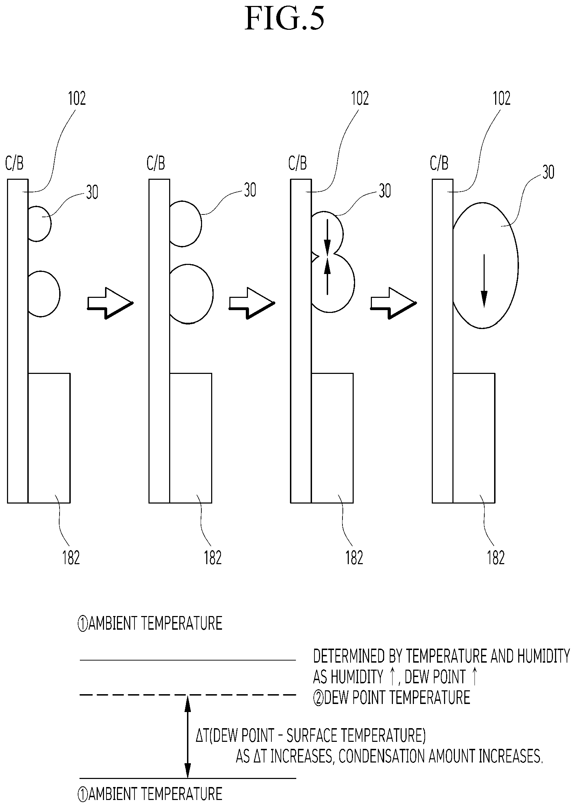

FIG. 5 is a diagram for explaining a condensation phenomenon. A dew drop 30 refers to a phenomenon, when the surface temperature of an object 102 is less than or equal to a dew point, moisture contained in the surrounding air is condensed and formed on the surface of the object 102. The dew point may vary depending on the surrounding temperature and humidity, and when the surface temperature of the object is lower than the temperature of the dew point, a degree of condensation may increase.

At first, the size of the dew drop 30 formed on the surface of the object is small, but as the dew drop 30 gradually grows and merges with a neighboring dew drop 30, and when the diameter becomes more than about 2.5 mm, the dew drop 30 flows down in a direction of gravity along the surface of the object.

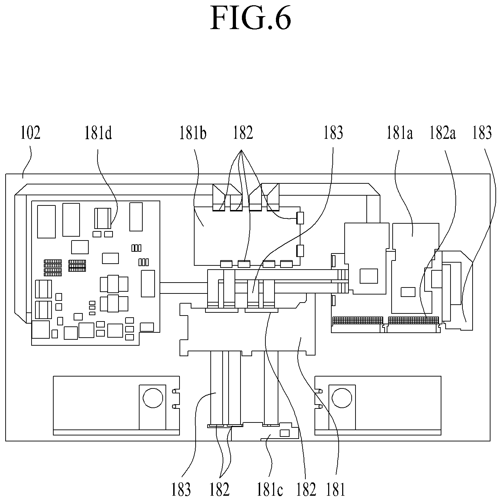

FIG. 6 is a diagram illustrating an example of an electronic component disposed on a rear surface of the cover bottom 102 of the display device 100, according to the present disclosure. Electronic components 181a, 181b, 181c, 181d, and 182 required for controlling the display device 100 are illustrated.

A main board 181a for controlling the entire display device 100, a power board 181b distributing power, and a sensor may be mounted, or a circuit board 181 such as a sub-board 181c connected to the display module 150 may be positioned. Various ICs may be mounted on each circuit board, and a cable may be used to transmit and receive signals between the boards.

An electronic device such as the display device 100 needs to stably transmit a large amount of transmitted and received signals, and thus a flexible flat cable (FFC) may be used. The FFC may cover a signal line, and a plurality of signal lines may be arranged side by side by a predetermined pitch (for example, 0.3 mm, 0.5 mm, and 1.0 mm) in a horizontal direction.

A flexible printed circuit (FPC) may be used as a signal line (cable) connecting components or between the circuit boards 181a, 181b, 181c, and 181d.

The flexible printed circuit board is a thin insulating polymer film having a conductive circuit pattern attached thereto and may be coated with a polymer to protect a conductor circuit, and single-layer, double-sided, multi-layered circuit lines may be arranged thereon.

Hereinafter, the flexible cable 183 includes a flexible flat cable and a flexible printed circuit board in the meaning of including a flexible and flat cable. The flexible cable 183 is described in a manner of including all members connected to the cable connector 182 by connecting a space in the circuit board 181. As a concept including a flexible printed circuit board,

the circuit board 181 may include a cable connector 182 into which a cable is inserted. A user may easily connect the flexible flat cable or the flexible printed circuit board to the cable connector 182 in a plug-in manner, that is, by inserting the flexible flat cable or the flexible printed circuit board into the cable connector 182.

The cable connector 182 has a disadvantage in that a secondary process is required and a large size is required to form an exposed terminal, but the cable connector 182 may be easily coupled and separated to be used for connection between the circuit boards 181.

The cable connector 182 to which the flexible flat cable (FFC) is coupled is exposed to the outside such that when water flows into a terminal, the cable connector 182 may cause a short circuit, and may cause malfunction, failure, or fire.

When the components are attached to the same circuit board 181 and are not separated from each other in the case of parts, soldering may be performed. For soldering, an insulating material on the surface of the circuit board 181 is removed and the copper foil is exposed, and thus when water is introduced into the exposed portion of the copper foil, a defect, a failure, and a fire may also be caused.

The electronic component mounted on the surface of the cover bottom 102 is vulnerable to the inflow of water, and thus the housing 101 and 102 may have a waterproof structure, but it is difficult to prevent condensation on the surface of the metallic member such as the cover bottom 102.

In particular, when the display device 100 is not used in a high temperature and high humidity area, the temperature of the cover bottom 102 may be relatively lowered, and particularly condensation may occur at dawn.

The present disclosure relates to the display device 100 that limits an operation of the display device 100 to guide a user to detect occurrence of condensation in advance, remove dew drops, and prevent a failure. The present disclosure is described based on a display device, but may also be applied to a general home appliance that does not include the display module 150. However, the display device 100 includes a metal having a large area like the cover bottom 102, and thus the display device 100 may be useful when being applied to the display device 100 having a high risk of condensation.

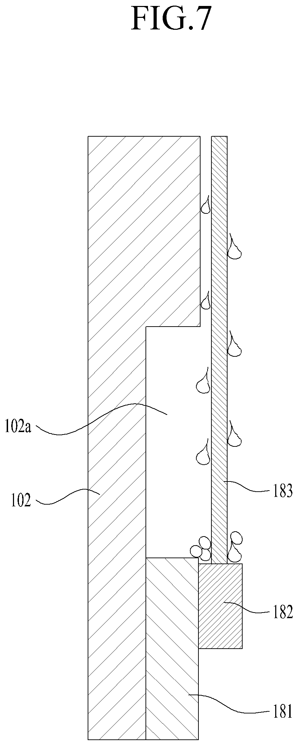

FIG. 7 is a diagram illustrating a side view for explaining a condensation phenomenon through a flexible cable 183.

The flexible cable 183 includes a connection part 1831 having a signal line located therein and a terminal part located at both ends of the connection part 1831 and including an electrode connected to the signal line. The terminal part may include a first terminal part 1832 and a second terminal part 1833. The terminal part may be inserted into a cable connector 182 to be connected to an electrode of the cable connector 182.

The flexible cable 183 may have a coated surface to protect a cable, a groove extending in a length direction, and a smooth surface. Condensation formed on the cover bottom 102 may move along the flexible cable 183 extending in the length direction.

The flexible cable 183 may be disposed in various directions. When the flexible cable 183 is disposed in a vertical direction, as illustrated in FIG. 7, it may cause a problem that condensation moves along the flexible cable 183 so as to flow to the electrode of the cable connector 182. For convenience of description, a terminal part located at a lower portion of the terminal part 1832 is referred to as the first terminal part 1832 and a terminal part located at an upper portion of the terminal part 1832 is referred to as the second terminal part 1833.

A recessed part 102 may be concavely formed on the cover bottom 102 to prevent condensation from flowing along the surface of the cover bottom 102 to the cable connector 182, but water droplets may still move along the smooth surface of the flexible cable 183.

In particular, since the flexible cable 183 may partially contact the cover bottom 102, the condensation of the cover bottom 102 may be gathered and introduced into the cable connector 182 along the flexible cable 183.

To solve this problem, a drip tray 185 may be further included.

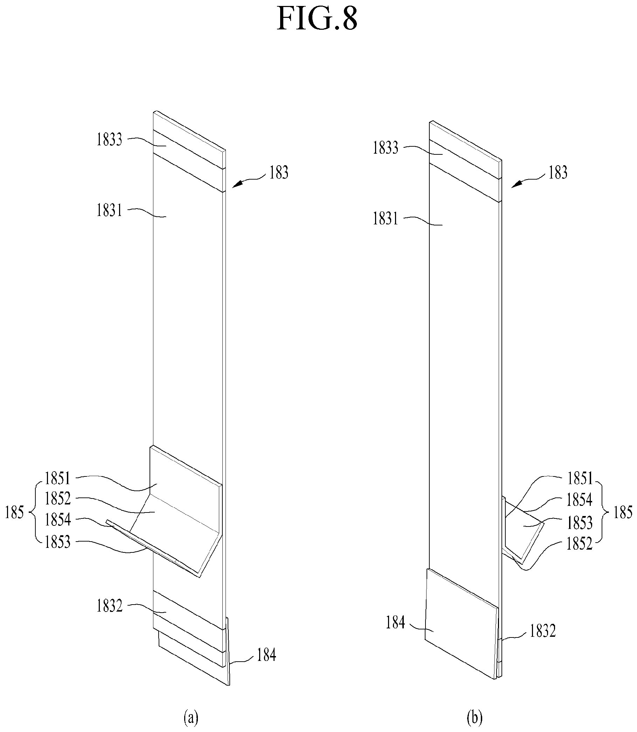

FIG. 8 is a diagram illustrating a flexible cable 183 according to the present disclosure. FIG. 8 (a) is a perspective diagram viewed in a direction of one surface of the flexible cable 183, and FIG. 8 (b) is a perspective diagram viewed in a direction of the other surface of the flexible cable 183.

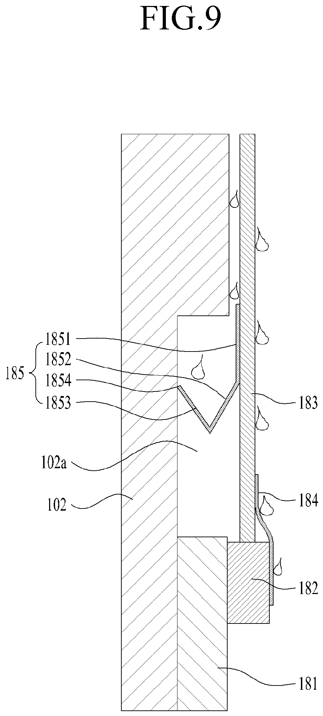

FIG. 9 is a diagram illustrating a side view of an embodiment in which the flexible cable 183 of the present disclosure is applied.

The drip tray 185 is disposed on the connection part 1831 of the flexible cable 183 and includes a gutter 1852 and 1853 that blocks water droplets flowing down along the connection part 1831.

As shown in FIG. 9, the cover bottom 102 may include a board seating part 102a concavely formed to have the circuit board 181 seated thereon, and the drip tray 185 may be disposed in a space between the board seating part and the flexible cable 183.

In order to attach the gutter 1852 and 1853 to the connection part 1831, the drip tray 185 may include an adhesive part. The drip tray 185 may include a waterproof material, and may use a material having rigidity to support a predetermined amount of water droplets.

In order to implement the drip tray 185 at a low cost without affecting the installation of the flexible cable 183, the drip tray 185 may be implemented in a manner of bending a plastic plate. More specifically, the gutter 1852 and 1853 may be implemented by bending the plastic plate twice.

The gutter 1852 and 1853 may include a first folding part 1852 that is primarily bent at the adhesive part and a second folding part 1853 that is further bent from the first folding part 1852 to be disposed in a V-shape with the first folding part 1852.

The first folding part 1852 and the second folding part 1853 may have a symmetrical shape, and an angle 2θ formed by the first folding part 1852 and the second folding part 1853 may be double an angle θ formed by the first folding part 1852 and one surface of the flexible cable 183.

For example, when θ is 90°, the angle formed by the first folding part 1852 and the second folding part 1853 may become 90°, and water drops may gather between the first folding part 1852 and the second folding part 1853 to be prevented from flowing toward the first terminal part 1832.

Since the rigidity of the drip tray 185 made by bending plastic is not large, as shown in FIG. 9, the drip tray 185 may be disposed to face the cover bottom 102, and an end portion 1854 thereof may be disposed to be in contact with the cover bottom 102.

In order to more stably support the drip tray 185, as shown in FIG. 9, a hanging protrusion 102b may be formed at a portion that comes in contact with the end portion 1854 of the drip tray 185 or a groove into which the end portion 1854 of the drip tray 185 is inserted may be formed.

The drip tray 185 may be disposed adjacent to the second terminal part 1833 to prevent the condensation flowing along the flexible cable 183 from being introduced into the cable connector 182.

Although water droplets flowing along the other surface of the flexible cable 183 may be relatively less than those flowing along one surface facing the cover bottom 102, they may be generated as well, and thus a drip cover may be further included to protect the other surface of the first terminal part 1832.

The drip tray 185 has the gutter 1852 and 1853 that stores water to prevent the water from going into the cable connector 182, while the drip cover 184 covers the cable connector 182, as shown in FIG. 9, so that water bypasses the cable connector 182 to flow.

Since the drip cover 184 may be formed of the same material as the drip tray 185 and does not include the gutter 1852 and 1853, the drip cover 184 may be attached to the other surface of the connection part 1831 to be adjacent to the first terminal part 1832, and may extend to cover the first terminal part 1832. As described above, the electronic device of the present disclosure may prevent the condensation from being introduced into the cable connector 182 by blocking or bypassing the flow path through which the condensation flows.

Since the damage caused by the inflow of moisture can be prevented, the lifespan of the product can be increased.

In addition, the present disclosure may be implemented by attaching only a simple structure to the existing flexible cable 183, and thus may be easily applied and performed in the same manner as the existing installation method on installing the flexible cable 183.

The above detailed description should not be construed as being limitative in all terms, but should be considered as being illustrative. The scope of the present disclosure should be determined by reasonable analysis of the accompanying claims, and all changes in the equivalent range of the present disclosure are included in the scope of the present disclosure.

## Claims

1. An electronic device, comprising:
a case of a metal material;
a circuit board located on a surface of the case;
a cable connector located on the circuit board; and
a flexible cable having an end portion inserted into the cable connector to be connected to another component, the flexible cable comprising:
a connection part having a signal line located therein;
a terminal part having an electrode located at each of both end portions of the connection part to be connected to the signal line; and
a drip tray located on one surface of the connection part.

2. The electronic device of claim 1, the drip tray comprising:
an adhesive part located at one end to be attached to the flexible cable; and
a gutter extending from the adhesive part to be concavely bent.

3. The electronic device of claim 2, the gutter comprising:
a first folding part bent in a direction spaced apart from the adhesive part; and
a second folding part bent at the first folding part to form a V-shaped gutter with the first folding part.

4. The electronic device of claim 3, wherein an angle between the first folding part and the second folding part is twice greater than that formed between the first folding part and the flexible cable.

5. The electronic device of claim 2, the terminal part comprising:
a first terminal part located at a lower end portion of the flexible cable; and
a second terminal part located at an upper end portion of the flexible cable,
wherein the gutter has a shape protruding toward the first terminal part.

6. The electronic device of claim 5, wherein the drip tray is located adjacent to the first terminal part.

7. The electronic device of claim 6, wherein one surface of the connection part faces the case.

8. The electronic device of claim 7, wherein the other end of the drip tray is in contact with the case.

9. The electronic device of claim 1, wherein the drip tray is a waterproof and rigid material.

10. The electronic device of claim 1, further comprising a drip cover attached adjacent to the terminal part of the other surface of the flexible cable to cover the terminal part,
wherein the drip cover covers the cable connector when the flexible cable couples to the cable connector.

11. A flexible cable, comprising:
a connection part having a signal line located therein;
a terminal part located at each of both end portions of the connection part and having an electrode connected to the signal line; and
a drip tray located on one surface of the connection part.

12. The flexible cable of claim 11, the trip tray comprising:
an adhesive part located at one end to be attached to the flexible cable; and
a gutter extending from the adhesive part to be concavely bent.

13. The flexible cable of claim 12, the gutter comprising:
a first folding part bent in a direction spaced apart from the adhesive part; and
a second folding part bent at the first folding part to form a V-shaped gutter with the first folding part.

14. The flexible cable of claim 13, wherein an angle between the first folding part and the second folding part is twice greater than that formed between the first folding part and the flexible cable.

15. The flexible cable of claim 12, the terminal part comprising:
a first terminal part located at a lower end portion of the flexible cable; and
a second terminal part located at an upper end portion of the flexible cable,
wherein the gutter has a shape protruding toward the first terminal part.
